Europäisches Patentamt

European Patent Office

Office européen des brevets

(19)

(11) EP 0 695 116 B1

(12) **EUROPEAN PATENT SPECIFICATION**

(45) Date of publication and mention
of the grant of the patent:
**28.01.2004 Bulletin 2004/05**

(51) Int Cl.[7]: **H05K 1/03**, C08K 3/00
// (C08K3/00, 3:22, 9:04)

(21) Application number: **95110620.2**

(22) Date of filing: **07.07.1995**

(54) **Fluoropolymer composites containing two or more ceramic fillers to achieve independent control of dielectric constant and dimensional stability**

Fluorpolymer-Verbundmaterialien mit zwei oder mehreren keramischen Füllern zur unabhängigen Kontrolle über Dimensionsstabilität und Dielektrizitätskonstante

Polymères fluorés composites contenant deux ou plusieurs charges céramiques pour opérer un contrôle indépendant de la constante diélectrique ainsi que de la stabilité dimensionique

(84) Designated Contracting States:
**DE FR GB IT**

(30) Priority: **29.07.1994 US 283301**

(43) Date of publication of application:
**31.01.1996 Bulletin 1996/05**

(73) Proprietor: **WORLD PROPERTIES, INC.**
**Lincolnwood, Illinois 60646 (US)**

(72) Inventors:
• **Horn II, Allen F.**
**Danielson, CT 06239 (US)**

• **Daigle, Robert C.**
**Sterling, CT 06377 (US)**
• **Kuszaj, Michael S.**
**Dayville, CT 06241 (US)**

(74) Representative: **Freylinger, Ernest T. et al**
**Office Ernest T. Freylinger**
**234, route d'Arlon**
**B.P. 48**
**8001 Strassen (LU)**

(56) References cited:
**FR-A- 2 608 616**     **US-A- 5 358 775**

**Description**

This invention relates generally to filled fluoropolymeric composites. More particularly, this invention relates to a fluoropolymeric composite for use as an electrical substrate material which exhibits both a high dielectric constant (K') and a low coefficient of thermal expansion (CTE).

Fluoropolymer (predominantly PTFE) matrix composites are widely used as substrates in the microwave frequency circuit board industry due to the excellent electrical properties, high temperature resistance and outstanding solvent resistance of PTFE. These materials are often supplied as copper foil-clad sheets. The copper foil is generally attached to the fluoropolymer dielectric layer by lamination in a flat bed press or autoclave at a temperature above the melting point of the fluoropolymer dielectric.

When the sheets are processed into circuits, portions of the conductive foil are selectively removed and the sheet will undergo a dimensional change due to the strain relief. As will be understood by those skilled in the art, it is undesirable to have a circuit board which changes in dimension substantially when processed to remove a portion of the copper foil.

The problems associated with the dimensional stability of circuit board substrates in general is widely known throughout the circuit processing industry. The Institute for Interconnecting and Packaging Electronic Circuits (IPC) publishes a manual describing standard test methods for circuit materials (IPC-TM-650). IPC-TM-650 Method 2.2.4B describes the test for quantifying the dimensional stability of flexible dielectric materials upon complete removal by etching of the copper cladding. IPC-TM-650 2.4.39A describes the test method for measuring the dimensional stability of woven-glass reinforced thin laminates.

Many of the general types of fluoropolymeric circuit board substrates are described in "Specification for Plastic Substrates, Clad or Unclad for High Speed/High Frequency Interconnections" (Document IPC-L-125). The eight general types are described in sections IPC-L-125/01 to IPC-L-125/08.

Fluoropolymer substrate types 1 to 5 are low dielectric constant materials, with the K' ranging from 2.15 to 2.65. These materials are composites of PTFE and glass fiber; types 1, 2 and 5 are reinforced with woven glass fabric while types 3 and 4 are reinforced with non-woven E-glass fibers.

With these types of materials, the dielectric constant and the dimensional stability both depend on the content of glass fiber reinforcement and cannot be independently controlled.

Rogers Corporation's RT/duroid® 5870 is a commercially available example of IPC-L-125 type 3 material, reinforced with approximately 13 weight % non-woven E-glass fibers. RT/duroid® 5870 exhibits a K' of 2.33 and a specified maximum dissipation factor of 0.0012. A 0.25 mm (0.010") thick specimen of RT/duroid® 5870 exhibits dimensional shrinkage of about 0.1% in the machine direction and 0.2% in the cross machine direction when tested by the IPC dimensional stability method.

Rogers' RT/duroid® 5880 is a commercially available example of IPC-L-125 type 4 material, reinforced with approximately 8 weight % non-woven, E-glass, with improved electrical properties. RT/duroid® 5880 exhibits a K' of 2.20 and a maximum specified dissipation factor of 0.0009. The improvement in the electrical performance of this material is due to the lower content of the E-glass reinforcement. The reduction in the E-glass content, however, results in poorer dimensional stability due to the greater mismatch between the CTE of the copper cladding and that of the fluoropolymeric composite substrate. A 0.25 mm (0.010") thick sample of RT/duroid® 5880 will exhibit dimensional shrinkage of about 0.2% in the machine direction and 0.4% in the cross machine direction when tested by the IPC method. The larger dimensional change of RT/duroid® 5880 increases the expense of circuit fabrication when this material is used. Special techniques such as "double etch" and strain relief are required to make precision microwave circuits when a substrate with the improved electrical properties and low E-glass content such as RT/duroid® 5880 is required. An additional problem with substrates with a poor CTE match to copper is that they can exhibit substantial "curl" when the copper cladding is removed predominantly from one side of the material.

IPC-L-125 type 6 specifies a class of ceramic-powder filled, low K' (K' < about 3) fluoropolymeric composite substrates. This type of fluoropolymer composite is also useful in certain applications for microwave laminates and is described in US Patent 4,849,284. A preferred embodiment of this invention is sold by Rogers Corporation to the microwave circuit board industry under the trademark RT/duroid® 6002. This composite material consists of approximately 60 volume % fused amorphous silica, about 39 volume % PTFE and about 1 volume % E-glass microfibers. It exhibits a K' of 2.94, a Z-axis CTE of about 24 ppm/°C, an XY-axis CTE of about 17 ppm/°C and a dimensional stability of about +0.05% when measured on a 0.25 mm (0.010") substrate. This small change in dimension upon removal of the copper cladding greatly facilitates the manufacture of precision circuitry and reduces the cost of fabrication. When the absolute change in dimension is less than about $10^{-3}$ (1 mil/inch), the special processing such as the double etch and stress relief can be eliminated. The closer match of the composite CTE to that of the copper cladding also virtually eliminates problems associated with curl when the copper is removed from one side of the material.

One drawback of this material, however, is that the maximum dielectric constant attainable is about 3.0. A further drawback is that the dielectric constant cannot be varied (even below the highest attainable value of about 3) independently from the dimensional stability. A reduction in the silica filler content would be necessary to decrease the composite's K'; and that same reduction in filler content would cause the XY CTE of the composite to increase and result in poor dimensional stability.

A need also exists for comparatively high K' (K' > 4) fluoropolymeric composite materials such as those described in US Patent 4,335,180. Preferred embodiments of this invention are sold by Rogers Corporation under the trademark RT/duroid® 6006 (K' = 6.15) and RT/duroid® 6010 (K' of 10.2 to 10.8). This class of materials is generally made by adding titania ceramic filler to control the K' of the material. The ceramic filler content also controls the material's CTE and dimensional stability.

It will be appreciated that independent control of K' and CTE is not possible with the aforementioned single filler systems. A high K' substrate with a K' of 10.2 exhibits a z-axis CTE of about +45 ppm/°C and a dimensional change upon etch and bake of about -0.2% to -0.4%. A high K' substrate with a K' of 6.15 exhibits a z-axis CTE of about +80 ppm/°C and a very large dimensional change upon etch and bake of about -0.4% to -0.8%. These materials also exhibit significant curl when the copper foil cladding is removed from one side of the laminate, due to the poor match of composite CTE and cladding CTE.

The high z-axis CTE, the poor dimensional stability and the tendency to curl are all highly undesirable properties of these materials. Historically, designers and users of PTFE composite microwave circuitry have simply had to work around these deficiencies if a high K' material was required. Thus, there continues to be a need for dimensionally stable, high K microwave laminates.

The above-discussed and other problems and deficiencies of the prior art are overcome or alleviated by the fluoropolymeric composite of the present invention which is well suited for use as an electrical substrate.

The object of the invention is to provide independent control of the K' and CTE (e.g., dimensional stability) of fluoropolymer microwave laminates.

In accordance with the present invention, there is provided an electrical substrate composite material comprising

(1) a fluoropolymeric matrix;
(2) particulate ceramic filler material, said filler material being characterized by a mixture of

(a) at least one first ceramic material having a K'> 30; and
(b) at least one second ceramic material having a chemical composition distinct from said first ceramic material, said mixture of ceramic fillers being proportioned in a ratio effective to provide the composite material with a dimensional stability of absolute magnitude of less than about 0.1% change.

One of the advantages of the present invention is that the control of the K' and CTE (e.g., dimensional stability) of fluoropolymer microwave laminates are independent one form the other. This capability allows the manufacture of microwave laminates with any specified K' (within the achievable range) and with an XY CTE of the material nearly matched to that of copper, resulting in good dimensional stability during circuit fabrication.

The composite material of this invention includes at least two types of ceramic fillers.. The two or more fillers are necessary to be able to independently control the K' and the CTE of the composite, thereby achieving a dimensional stability of absolute magnitude less than 0.1% change. At least one type of ceramic filler exhibits a K' of greater than 30 while the other types of ceramic filler may exhibit a K' of any value; although the second ceramic filler preferably has a K' of less than about 30 to facilitate the use of conventional fillers and to facilitate the tailoring of the final dielectric constant for the laminate

One preferred application of the present invention is to make microwave laminates with the XY (in-plane) CTE of the composite nearly matched to that of copper and the K' controlled to a specified value within the range of 3.0 to 20. This application of the present invention requires high filler contents; preferably greater than 50 volume %. The CTE match is necessary to achieve good dimensional stability as measured by IPC TM 650 2.2.4B. K' control to a specific value is often required to meet a specific application's electrical requirements; and therefore the ability of the present invention to be tailored to specific K values represents an important advantage.

An additional advantage of the present invention is that low Z-axis CTE substrates with high K' can be made, leading to better plated though-hole reliability.

In a preferred embodiment, the invention consists of a composite fluoropolymeric (e.g., PTFE) material containing at least two chemically different ceramic fillers. The total volume fraction of the two fillers may cover the range of about 0.5 to 0.70 on a void-free basis, while the volume fraction of the fluoropolymer may range from about 0.3 to 0.5.

The total volume fraction of the combined fillers is effective to achieve a dimensional stability (also known as Dim Stab) of an absolute value of less than about 0.1%. As discussed in detail in the examples below, the volume loading of filler required to achieve this dimensional stability value will depend on the CTE of the two or more fillers, their particle size distributions (PSD) and particle morphology. In a preferred embodiment, improved dimensional stability occurs when the total volume filler loading is in the 0.5 to 0.7 range.

The fluoropolymeric matrix is most preferably polytetrafluoroethylene (PTFE), but may also comprises one or a combination of the following fluoropolymers: a copolymer of tetrafluoroethylene and perfluoroalkyl vinyl ether (PFA), a copolymer of hexafluoropropylene and tetrafluoroethylene (FEP), poly(ethylene-co-tetra fluoroethylene) and poly(vinylidene fluoride).

Preferably, one of the two fillers will be at least one "high-K'" filler which exhibits a K' of greater than about 30. The second filler may have any K'. However, in a preferred embodiment, the second filler comprises at least one "low-K'" filler which will exhibit a K' of less than about 30. Other properties of the fillers are also important to yield a useful microwave substrate. The fillers must both exhibit a relatively low dielectric loss (< 0.005) at high frequencies (greater than 500 Mhz) The particle size distribution and particle morphology must be such that they will result in a composite with relatively low (less than about 10 volume %) porosity as measured by uptake of a low surface tension solvent such as xylene. The particles themselves must also not exhibit significant porosity in order to make a low porosity composite.

Certain types of titania filler such as Tionia, manufactured by SCM Corporation meet these requirements and provide a good high-K' filler. Other suitable first (high K') fillers include $SrTiO_3$, $CaTiO_3$ and $BaTiO_4$. Fused amorphous silica, such as Minsil-20, manufactured by Minsil, Incorporated or FB-35, manufactured by Denki Kagaku Kogyo, K.K. (DENKA) provides a good low-K' filler. Other siliceous materials such as micro-crystalline silica or glass beads may equally well be used as a "second" or low-K' filler. Still other suitable second (which may or may not be low K') fillers include $Al_2O_3$, MgO and $Ba_2Ti_9O_{20}$.

Once the total volume loading of filler is set, the relative ratio of the two fillers comprising the desired volume loading is determined by the desired dielectric constant of the material. Using f. ex. the SCM Tionia and Minsil-20 as the high-K' and low-K' fillers, respectively, a total volume content of filler of about 60% results in a circuit substrate that exhibits practically no dimensional change upon etch and bake when tested by the IPC method. To achieve f.ex. a K' of about 10, the volumetric ratio of titania to silica is set to approximately 50:10. To achieve f.ex. a K' of about 6, the volumetric ratio of titania to silica is set at about 34:26.

In another preferred embodiment of the invention, the two or more ceramic fillers are treated with a hydrophobic coating to improve the water absorption, ductility and copper bond strength of the fluoropolymeric composite material. Examples of efficacious and known hydrophobic coatings are silane coupling agents, titanates and zirconates.

The fluoropolymeric composite material may be fabricated by any of a number of methods previously described in both the patent and open literature. One fabrication process is essentially the same as the manufacturing process taught by Traut in US Patent No. 4,335,180. The process taught by Traut involves the dispersion of the ceramic filler and glass microfiber in water, the addition of fluoropolymer resin in dispersion form and the co-flocculation of the resin, filler and fiber. The present invention, however, does not require the incorporation of glass microfiber. The co-flocculated material is then lubricated with a hydrocarbon lubricant and formed into a sheet by paste extrusion and calendering. The content of hydrocarbon lubricant may vary form about 14% to 25% by weight, depending on the specific gravity, PSD, and morphology of the ceramic fillers.

A second fabrication process eliminates the use of water as a dispersant. In this "dry-blending" process, taught by Horn in S.N. 08/099,245, now US Patent 5,358,775, PTFE "fine powder" resin is blended with the ceramic fillers in a mixing device such as a Patterson Kelly Vee Blender along with the hydrocarbon lubricant and then formed into a sheet by paste extrusion and calendering.

A third fabrication process, taught by Swei et al in US Patent 5,312,576, causes the fillers and PTFE dispersion to be mixed and the viscosity increased with a viscosifying agent. The thickened mixture is then cast upon a carrier sheet and dried in an oven. The viscosifying agent is removed thermally and the composite material is sintered in a high temperature oven and released from the carrier sheet. This process is particularly well suited for the production of thin (less than 0.127 mm (0.005")) sheets.

A number of methods may be used to apply the hydrophobic coating to the ceramic fillers. The fillers may be "pre-treated" as described by Arthur et al. in US Patent No. 4,849,284. The hydrophobic coating may also be introduced to the filler-PTFE mixture with the hydrocarbon lubricant as described in S.N. 08/099,235. The hydrophobic coating may also be introduced in the aqueous mixture of fillers and PTFE dispersion in the casting process. All of these processes have been practically demonstrated to improve the water absorption, ductility and copper peel strength over that of composites made with untreated filler.

The above-discussed and other features and advantages of the present invention will be appreciated and understood by those of ordinary skill in the art from the following detailed discussion and drawings.

Referring now to the drawings, wherein like elements are numbered alike in the several FIGURES:

FIGURE 1 is a cross-sectional elevation view of an electrical substrate laminate in accordance with the present invention;

FIGURE 2 is a graph showing the dimensional change versus the average XY-plane coefficient of thermal expansion (CTE);

FIGURE 3 is a graph showing % change in dimension versus volume % silica filler;

FIGURE 4 is a graph depicting how K' increases with an increased level of titania filler; and

FIGURE 5 is a graph depicting how dimensional change is affected by a change in the volume % of ash.

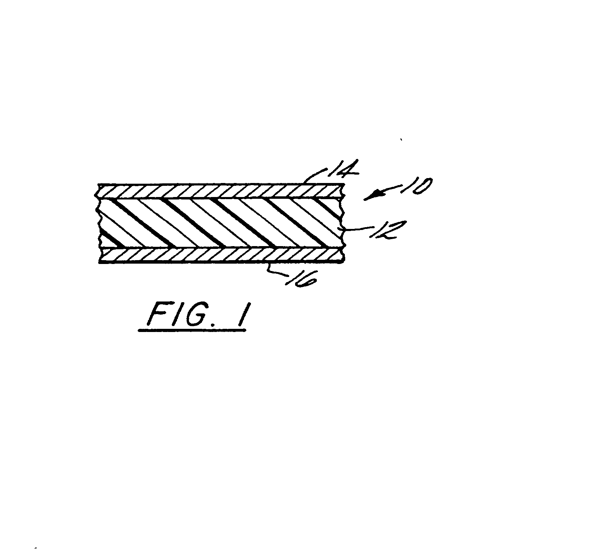

Referring to FIGURE 1, the filled fluoropolymeric composite is depicted in the form of a circuit laminate 10 where the composite 12 comprises a dielectric sheet laminated between conductive sheets 14, 16 (preferably metal sheets such as copper or aluminum).

The following non-limiting examples show the relationship between the laminates' XY coefficient of thermal expansion and the dimensional stability as measured by the IPC-TM-650 2.2.4b test. They further demonstrate the range of filler contents over which a good dimensional stability (absolute value of change of less than 0.1 %) can be achieved and show the ability of the present invention to vary the K' of the laminate without adversely affecting the dimensional stability.

EXAMPLE 1: The following examples demonstrates the relationship between the XY-plane coefficient of thermal expansion of a ceramic powder filled fluoropolymeric composite laminate and the dimensional stability as measured by IPC-TM-650 2.2.4b. Twelve different formulations of fused amorphous silica-PTFE composites were prepared with silica contents varying from about 50 volume % to 65 volume %. These materials were formed into sheets as described in US 5,358,775 and laminated as 0.52 mm (0.060") thick sheets to 315 g/m$^2$ (1 ounce/ft$^2$) electrodeposited copper foil in a flat bed lamination press.

The change in laminate dimensions was measured on the twelve formulations after complete copper removal and baking in accordance with the IPC-TM-650 test. Pieces of each formulation were also tested for coefficient of thermal expansion in the X and Y (in-plane) directions. Prior to CTE testing, the samples were heat-treated for stress relief. The heat-treating step consisted of placing the samples in an oven set to 371°C (700°F) for 30 minutes and then turning the heaters off and allowing them to slowly cool over a period of several hours to room temperature. The samples were tested for XY coefficient of thermal expansion over the temperature range of -55 to +288°C.

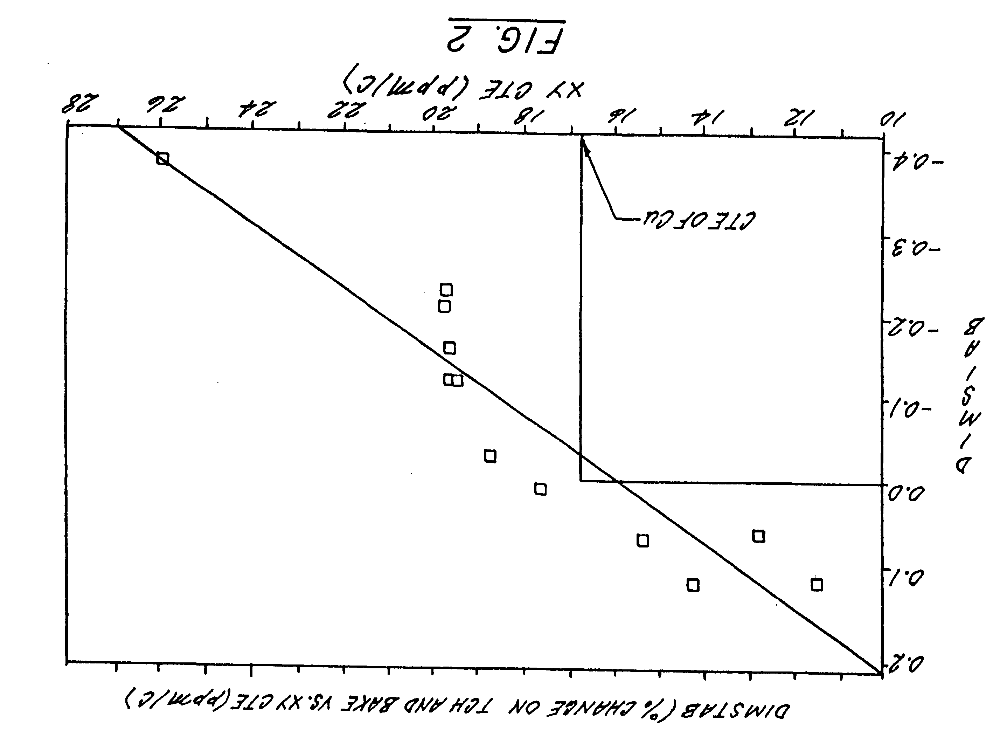

FIGURE 2 displays the dimensional change (reported as % change upon etch and bake) versus the average XY-plane coefficient of thermal expansion. The markers on the plot show that when the measured CTE of the composite is about 16.7 ppm/°C (matched to the CTE of the copper foil cladding), the dimensional change upon etch and bake is zero. This example clearly demonstrates that good dimensional stability can be achieved by matching the CTE of the composite material to that of the cladding foil. If the CTE of the composite material is higher than that of the foil cladding, the laminate will exhibit shrinkage when the copper is etched; if the CTE of the composite is lower than that of the foil cladding, the laminate will exhibit a positive dimensional change.

Furthermore, in order for the dimensional change to be less than about 0.1%, the composite XY-plane CTE must preferably be within the range of greater than 11 ppm/°C to less than 20 ppm/°C.

EXAMPLE 2: The following example demonstrates the relationship between filler volume loading and laminate dimensional stability for two different particle size distributions of filler.

The "Coarse PSD" sample of fused amorphous silica was produced by a dry ball milling process. It exhibited a median particle diameter of 9.5μm, with 85 weight% of the sample less than 29μm and 15% less than 4μm in equivalent spherical diameter as measured by the Shimadzu SA-CP4 particle size analyzer. The "Fine PSD" sample was produced by air classifying the Coarse PSD material and collecting the fines. The Fine PSD sample exhibited a 2.7μm median particle diameter, with 85 weight % of the sample less than 4.3μm and 15% less than 1.5μm.

Twenty formulations with Coarse PSD silica filler content ranging from 52% to 64% by volume were made into 0.52 mm (0.060") laminate by the method described in S.N. 08/ 099,245 and the dimensional stability of each was measured. An additional thirteen formulations with Fine PSD silica filler content ranging from 46% to 58% by volume were also made into 0.52 mm (0.060") laminate by the same method and the dimensional stability was also measured. The volume content of filler was measured by ashing the samples and is reported on a void-free basis.

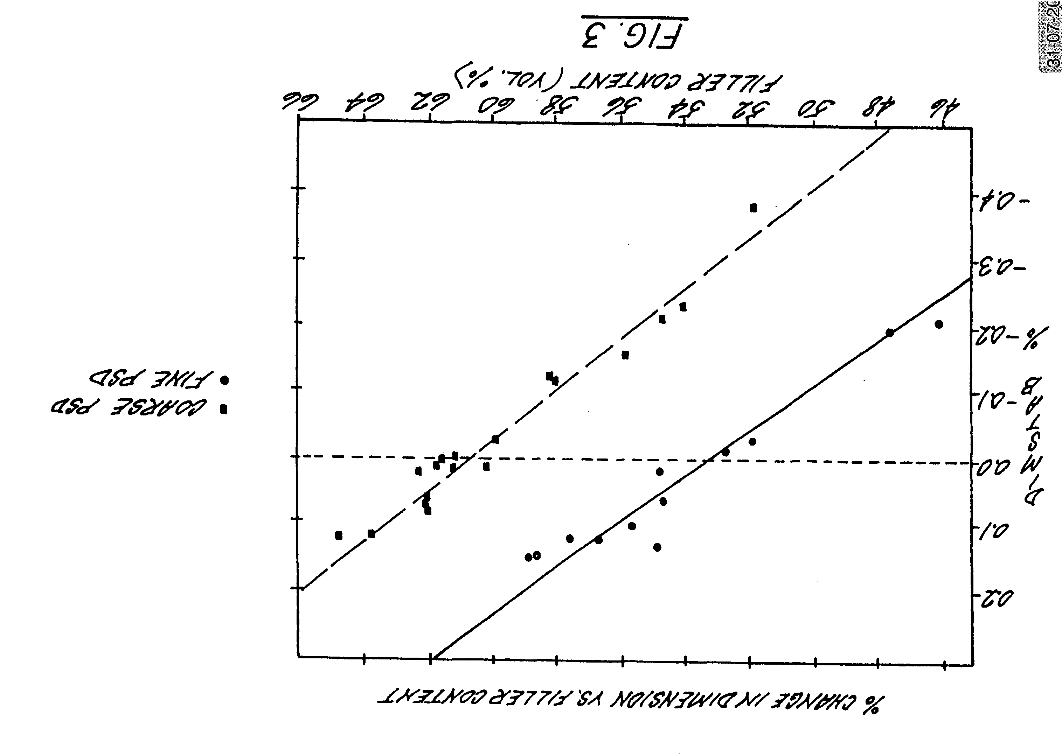

These data are plotted in FIGURE 3 as % change in dimension versus volume % silica filler. The equations of the least-squares fit lines through these two data sets are:

Coarse PSD:

$$\% \text{ Change} = 0.0384 \times (\text{vol. \% filler}) - 2.327$$

Fine PSD:

$$\% \text{ Change} = 0.0342 \times (\text{vol. } \% \text{ filler}) - 1.816$$

The "zero dimensional change" condition (ZDC) occurs at a filler content of 60.6 volume % for the substrates prepared with the Coarse PSD silica and at a filler content of 53.1 volume % for the substrates prepared with the Fine PSD silica. The difference in volume fraction of filler required to achieve ZDC is due to the difference in the particle size distributions of the two filler samples. The Fine PSD silica exhibits a higher specific surface area. It is well known that higher surface area mineral fillers are more effective at decreasing the coefficient of thermal expansion of a polymeric composite.

From the slopes of the dimensional change versus filler content graphs, one can calculate that increasing the filler content by 2.6 percentage points from the ZDC condition (e.g. from 60.6% to 63.2%) results in a dimensional change of +0.1% for the substrates made with the Coarse PSD silica. A decrease in filler content of the same magnitude would result in a dimensional change of - 0.1%. Similarly, one can calculate that a 2.9 percentage point increase in the Fine PSD filler content results in a dimensional change of +0.1%. Thus, in order to achieve a desirable dimensional stability in a ceramic powder filled PTFE composite, the volume content of filler must be within about 3 percentage points of that which results in zero dimensional change.

EXAMPLE 3: The following example demonstrates the ability to achieve good dimensional stability (less than 0.1% dimensional change) and maintain any desired dielectric constant within the range of about 4.0 to about 13 by utilizing a blend of two ceramic fillers. The good dimensional stability achievable with the present invention is compared with the poor dimensional stability of laminates made by the prior art.

Table 1 list the specific gravities and particle size distributions of both the high-K' and low-K' fillers used in this example.

TABLE 1

| Filler Specific Gravities and Particle Size Distributions | | | | |
|---|---|---|---|---|
| **Material** | **Sp.G.** | **Diameter 85% less than** | **Diameter Median** | **Diameter 15% less than** |
| A - High K' $TiO_2$-I [1] | 3.98 | 20.4µm | 14.2µm | 10.6µm |
| B - High K' $TiO_2$-II [2] | 4.26 | 4.3µm | 2.9µm | 1.9µm |
| C - Low K' FB-35 | 2.2 | 28.6µm | 9.5µm | 4.0µm |
| D - Low K' Minsil-20 | 2.2 | 26.2µm | 9.4µm | 3.0µm |
| E - Low K' $Al_2O_3$ [3] | 4.0 | 19.9µm | 13.6µm | 11.0µm |

[1] "Tionia" from SCM Corporation

[2] "TICON" from Tam Ceramics, a Cookson Company

[3] "EGPA" from Norton Corporation

Table 2 compares K', thickness and dimensional stability data for examples of the prior art including Rogers RT/duroid® 6010, RT/duroid® 6006 and Keene 810. The Rogers RT/duroid® substrates were produced as taught by Traut '180. All of the prior art materials exhibit dimensional changes upon etch and bake of worse than -0.2%. All of these materials require the special fabrication techniques such as double etch and strain relief in order to be made into useful high frequency circuitry. They are also known to curl under certain circumstances, leading to further fabrication problems.

The Keene material was considerably worse than RT/duroid® 6010 (about -0.7% change), probably due to the absence of glass microfiber. The dimensional change of the RT/duroid® 6006 is much worse (-0.6% to -0.8%) than RT/d 6010 due to the low volume loading of filler. The filler content of the RT/d 6006 is decreased in order to achieve the desired K' value of 6.15. The shrinkage and curl of RT/duroid® 6006 is known to be unacceptable to circuit substrate fabricators.

These data demonstrate the severe limitations of prior art high-K' circuit board substrates and the inability of the formerly existing technology to vary the K' of a circuit substrate and maintain a good dimensional stability.

TABLE 2

| Dimensional Stability, K' and thickness data for Prior Art High-K' PTFE Composite Circuit Substrates | | | | |
|---|---|---|---|---|
| **Material** | **Thickness** | **K'** | **Dimen. Stability % Change** | |
| RT/d 6010 | 0.25 mm (0.010") | 10.2 | MD | -0.20% |
| | | | CMD | -0.20% |
| RT/d 6010 | 1.27mm (0.050") | 10.2 | MD | -0.22% |
| | | | CMD | -0.21% |
| RT/d 6006 | 0.25 mm (0.010") | 6.15 | MD | -0.81% |
| | | | CMD | -0.64% |
| RT/d 6006 | 1.27 mm (0.050") | 6.15 | MD | -0.56% |
| | | | CMD | -0.56% |
| Keene 810 | 0.64 mm (0.025") | 10.2 | MD | -0.70% |
| | | | CMD | -0.62% |

Table 3 displays dimensional stability, K' and thickness data for the present invention. Samples 9901, 9902 and 9903 were produced by the method described by Swei in US Patent 5,312,576. Referring to table 3, sample 9901 was formulated to contain 45 vol.% filler B, 10 vol.% filler E and 45 vol.% PTFE on a void-free basis. Sample 9902 was made within 40 vol.% filler A, 15 vol.% filler E and 45 vol.% PTFE on the same basis. Sample 9903 contained 50 vol.% filler A, 10 vol.% filler C, and 40 vol.% PTFE. These materials all exhibited dimensional change upon etch and bake of an absolute value considerably less than 0.1%.

Sample 2039-53-4 was prepared by the method described by Horn in US 5,358,775 and was formulated to contain 50 vol.% filler A, 10 vol.% filler C and 40 vol.% PTFE. This material exhibited practically no measurable change in dimension upon etch and bake.

TABLE 3

| Dimensional Stability, K' and thickness data for Novel High-K' PTFE Composite Circuit Substrates with two ceramic fillers | | | | |
|---|---|---|---|---|
| **Material** | **Thickness** | **K'** | **Dimen. Stability % Change** | |
| 9901 | 0.64 mm (0.025") | 10.5 | MD | -0.01% |
| | | | CMD | -0.01% |
| 9902 | 0.64 mm (0.025") | 9.6 | MD | -0.03% |
| | | | CMD | -0.04% |
| 9903 | 0.64 mm (0.025") | 10.5 | MD | +0.05% |
| | | | CMD | +0.06% |
| 2039-53-4 | 0.64 mm (0.025") | 10.4 | MD | +0.01% |
| | | | CMD | 0.00% |
| 2069-50-2 | 0.64 mm (0.025") | 5.5 | MD | -0.01% |
| | | | CMD | 0.000% |
| 2069-51-1 | 0.64 mm (0.025") | 6.3 | MD | -0.03% |
| | | | CMD | -0.01% |

Samples 2069-50-2 and 2069-51-1 were prepared using the method described by Swei. Both samples were formulated with a total filler content of 58 volume %. Sample 2069-50-2 was made with 23.3 volume % of filler A, 34.8 volume % filler D and 42 volume % PTFE. Sample 2069-51-1 was made with 29.0 volume % of filler A, 29.0 volume % filler D and 42 volume % PTFE. The two samples were laminated as 0.64 mm (0.025") sheet to copper foil and tested for dielectric constant and dimensional stability. As shown in table 3, both samples exhibited excellent dimensional stability. The dielectric constants of the samples were 5.5 and 6.3, respectively.

EXAMPLE 4: This examples demonstrates the capability of the present invention to achieve a wide range of dielectric constants while maintaining a good dimensional stability of an absolute change of less than 0.1% when tested by IPC-TM-650 Test Method 2.2.4B.

Nineteen separate samples of PTFE-$TiO_2$-$SiO_2$ composite were prepared by the method described by Swei. The $TiO_2$ used in this example was filler A and the $SiO_2$ was filler D described in table 1. All nineteen samples had a total filler content of 57 to 61 volume %, the total filler consisting of a mixture of filler A and filler D. The titania content of the composite was varied from 0 to 50 volume % while holding the total filler content constant within the range of 57 to 61 volume %.

The materials were laminated to 315 g/m$^2$ (1 oz/ft$^2$) copper foil and tested for dimensional stability and dielectric constant. All nineteen samples exhibited an absolute dimensional stability of less than 0.1%, in contradistinction to the prior art materials listed in table 2. The dielectric constant was tested at x-band by a stripline resonance method.

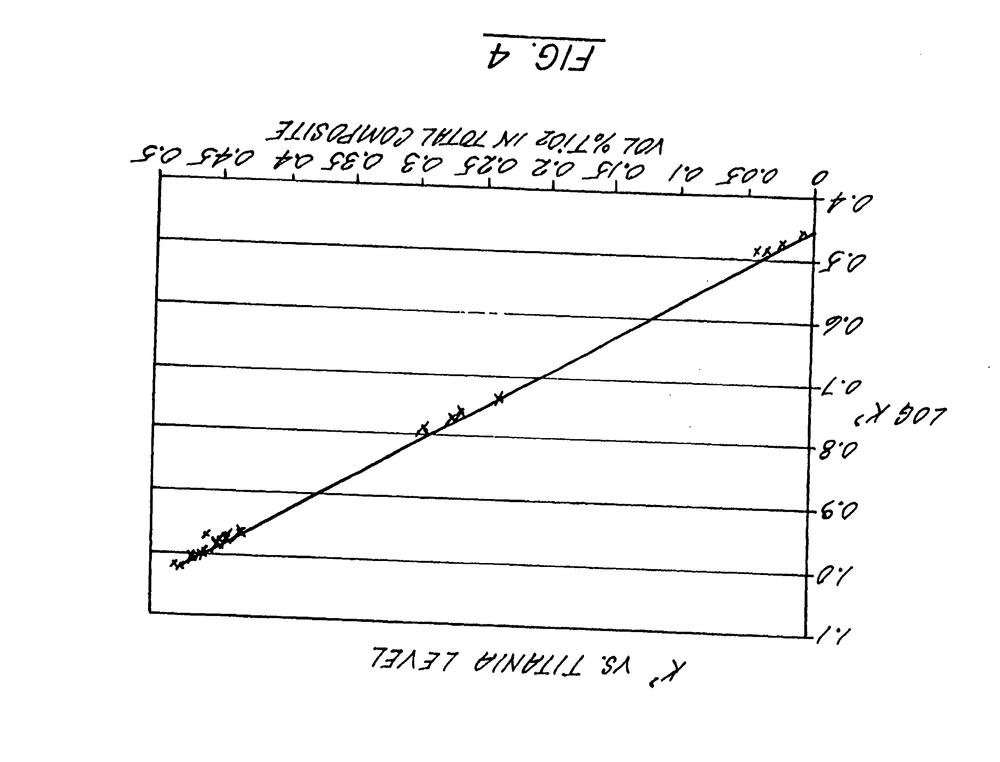

The dielectric constant results are plotted in FIGURE 4 as $\log_{10}K'$ versus the volume % of $TiO_2$ in the composite on a void-free basis. The data are fit by the equation

$$\log_{10}K' = 1.1896V_{TiO2} + 0.4565$$

where $V_{TiO2}$ is the volume fraction of titania in the composite. The graph demonstrates the wide range of dielectric constants that can be achieved while controlling the dimensional stability of the laminate. The data shown on the graph range from K' of 2.9 to K' of 10.2. Using the above equation to extrapolate the present data, a dielectric constant of 15.2 can be achieved with 61 volume % of filler. A PTFE composite containing 61 volume % of filler A titania would exhibit an absolute value of dimensional stability of less than 0.1%. The ability to vary dielectric constant over such a wide range without adversely changing the dimensional stability of the laminate material represents a vast improvement over the prior art materials.

EXAMPLE 5: This example demonstrates the capability of the present invention to "fine tune" the dimensional stability of a PTFE composite circuit substrate while maintaining a desired dielectric constant using the mixture of fillers. Nine composite samples were prepared using the method described by Swei. The material was formulated to contain from 57 to 61 volume % of total filler, the total filler consisting of a mixture of fillers A and D from table 1. The volume content of titania varied from 43.7% to 50.8%. The dielectric properties were measured at X-band frequency using a stripline resonator. The average K' was 9.90 with a standard deviation, of 0.46.

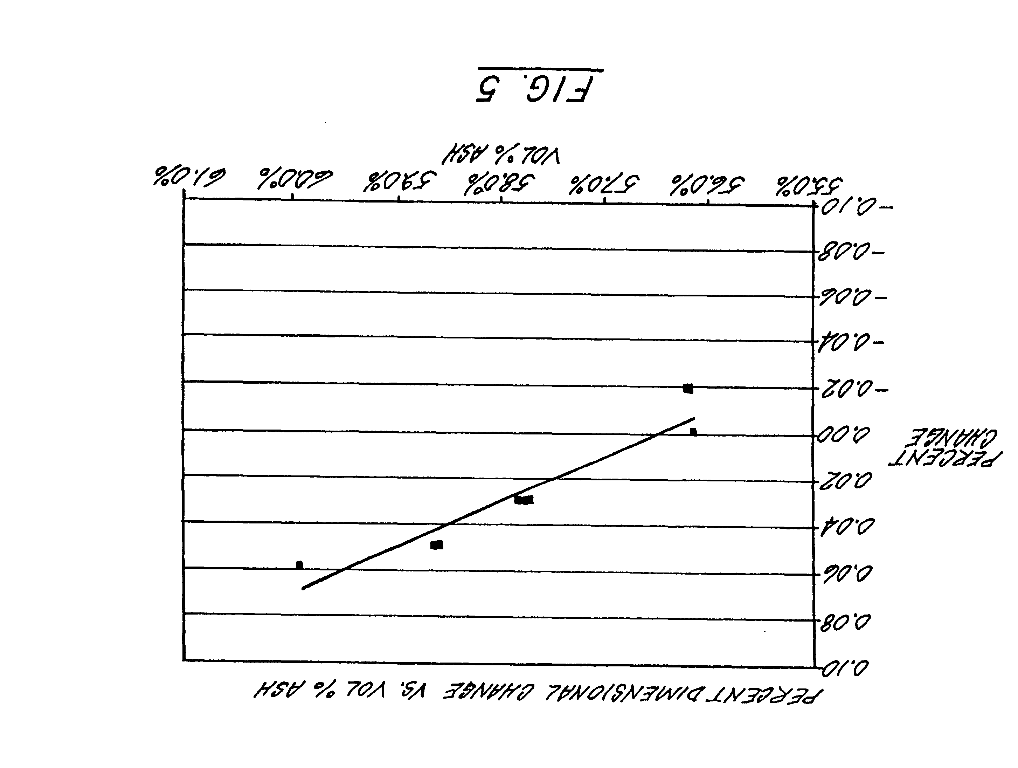

The actual filler content was determined by burning off the PTFE resin at 600°C in a muffle furnace under a vacuum of 737 mm (29") of Hg. The dimensional stability was measured in accordance with IPC-TM-650 2.4.4B. All samples exhibited a dimensional change of less than 0.1%. However, FIGURE 5 demonstrates that, at a total volume % of filler of 56.1%, a dimensional change of 0 can be achieved with the mixture of fillers.

**Claims**

1. An electrical substrate composite material comprising

    (1) a fluoropolymeric matrix;
    (2) particulate ceramic filler material, said filler material being **characterized by** a mixture of

        (a) at least one first ceramic material having a K'> 30; and
        (b) at least one second ceramic material having a chemical composition distinct from said first ceramic material, said mixture of ceramic fillers being proportioned in a ratio effective to provide the composite material with a dimensional stability of absolute magnitude of less than about 0.1 % change.

2. The material of claim 1 **characterized in that** said first ceramic material is selected from the group consisting of titania, $SrTiO_3$, $CaTiO_3$ and $BaTiO_4$.

3. The material of claim 1 or 2 **characterized in that** said second ceramic material is selected from the group consisting of fused amorphous silica, micro-crystalline silica, glass beads, $Al_2O_3$, MgO and $Ba_2 Ti_9O_{20}$.

4. The material of any of the claims 1 to 3 **characterized in that** said particulate filler material exhibits a dielectric of loss of < 0.005 at frequencies greater than 500 MHz.

**5.** The material of any of the claims 1 to 4 **characterized in that** said fluoropolymeric matrix is present in an amount of between about 30 to 50 volume percent of the total substrate material.

**6.** The material of any of the claims 1 to 5 **characterized in that** said filler material is present in am amount of between about 50 to 70 volume percent of the total substrate material.

**7.** The material of any of the claims 1 to 6 including a hydrophobic coating on said ceramic materials.

**8.** The material of claim 7 **characterized in that** said coating on said ceramic materials is selected from the group consisting of silanes, titanates and zirconates.

**9.** The material of any of the claims 1 to 8 including at least one metal layer on at least a portion of a surface of the composite material.

**10.** The material of claim 9 **characterized in that** the metal layer comprises copper.

**11.** The material of any of the claims 1 to 10 **characterized in that** said composite material has a planar shape and includes an X-Y plane and wherein the CTE of the composite material is substantially equal to the CTE of the copper.

**12.** The material of any of the claims 1 to 11 **characterized in that** said fluoropolymeric matrix is selected from the group consisting of polytetrafluoroethylene, a copolymer of tetrafluoroethylene and perfluoroalkyl vinyl ether, a copolymer of hexafluoropropylene and tetrafluoroethylene, poly(ethylene-co-chlorotrifluoroethylene), poly(chlorotrifluoroethylene), poly(ethylene-co-tetrafluoroethylene) and poly(vinylidene fluoride).

**13.** The material of any of the claims 1 to 12 **characterized in that** said composite material has a planar shape and includes an X-Y plane and wherein the coefficient of thermal expansion of said X-Y plane is within the range of greater than about 11 ppm/$^\circ$C and less than about 20 ppm/$^\circ$C.

**14.** The material of any of the claims 1 to 13 **characterized in that** said composite material has a planar shape and includes an X-Y plane and wherein
said filler material is present in a volume % which is within 3% of the volume % necessary for achieving a dimensional change of zero in said X-Y plane.

**15.** The material of any of the claims 1 to 14 **characterized in that** said composite material has a K in the range of 3.0 to 20.0.

**16.** The material of any of the claims 1 to 15 **characterized in that** said particulate ceramic filler is present in an amount of 60 volume % and wherein said first ceramic filler comprises titania; and said second ceramic filler comprises silica.

**17.** The material of claim 16 **characterized in that** the volumetric ratio of titania to silica is about 50:10.

**18.** The material of claim 16 **characterized in that** the volumetric ratio of titania to silica is about 34:26.

**19.** The material of any of the claims 1 to 18 **characterized by** at least one second ceramic material having a K' < 30.

**20.** The material of any of the claims 1 to 18 **characterized by** at least one second ceramic material having a K'< 30, said mixture of ceramic fillers being present in a volume % which is within 3% of the volume % necessary for achieving a dimensional change of zero.

**Patentansprüche**

**1.** Elektrisches Substrat-Verbundmaterial, umfassend:

1 ) eine Fluorpolymer-Matrix; und
2) ein aus Partikeln bestehendes keramisches Füllermaterial, wobei das Füllermaterial **gekennzeichnet ist durch** eine Mischung aus

a) mindestens einem ersten Keramikmaterial mit einer K' > 30; und

b) mindestens einem zweiten Keramikmaterial, dessen chemische Zusammensetzung sich von der des ersten Keramikmaterials unterscheidet,

wobei die Mischung der keramischen Füller so in einem wirksamen Verhältnis dosiert ist, dass das Verbundmaterial eine Dimensionsstabilität mit einer absoluten Größenänderung unter ca. 0, 1 % aufweist.

**2.** Material nach Anspruch 1, **dadurch gekennzeichnet, dass** das erste Keramikmaterial aus der Gruppe bestehend aus Titandioxid, $SrTiO_3$, $CaTiO_3$ und $BaTiO_4$ ausgewählt wird.

**3.** Material nach Anspruch 1 oder 2, **dadurch gekennzeichnet, dass** das zweite Keramikmaterial aus der Gruppe bestehend aus amorphem Quarzglas, mikrokristallinem Quarzglas, Glaskugeln, $Al_2O_3$, MgO und $Ba_2Ti_9O_{20}$ ausgewählt wird.

**4.** Material nach irgendeinem der Ansprüche 1 bis 3, **dadurch gekennzeichnet, dass** das aus Partikeln bestehende Füllermaterial einen dielektrischen Verlust von < 0,005 bei Frequenzen über 500 MHz aufweist.

**5.** Material nach irgendeinem der Ansprüche 1 bis 4, **dadurch gekennzeichnet, dass** die Fluorpolymer-Matrix in einer Menge zwischen ca. 30 und 50 Volumenprozent des gesamten Substratmaterials vorhanden ist.

**6.** Material nach irgendeinem der Ansprüche 1 bis 5, **dadurch gekennzeichnet, dass** das Füllermaterial in einer Menge zwischen ca. 50 und 70 Volumenprozent des gesamten Substratmaterials vorhanden ist.

**7.** Material nach irgendeinem der Ansprüche 1 bis 6, einschließlich einer wasserabweisenden Beschichtung auf den Keramikmaterialien.

**8.** Material nach Anspruch 7, dadurch gekennzeichent, dass die Beschichtung auf den Keramikmaterialien aus der Gruppe bestehend aus Silanen, Titanaten und Zirconaten ausgewählt wird.

**9.** Material nach irgendeinem der Ansprüche 1 bis 8, einschließlich mindestens einer Metallschicht auf mindestens einem Teil einer Oberfläche des Verbundmaterials.

**10.** Material nach Anspruch 9, **dadurch gekennzeichnet, dass** die Metallschicht Kupfer umfasst.

**11.** Material nach irgendeinem der Ansprüche 1 bis 10, **dadurch gekennzeichnet, dass** das Verbundmaterial eine ebene Form hat und eine X-Y-Ebene einschließt, und

wobei der Wärmeausdehnungskoeffizient (WAK) des Verbundmaterials im Wesentlichen dem WAK des Kupfers gleicht.

**12.** Material nach irgendeinem der Ansprüche 1 bis 11, **dadurch gekennzeichnet, dass** die Fluorpolymer-Matrix aus der Gruppe bestehend aus Polytetrafluorethylen, einem Copolymer von Tetrafluorethylen und Perfluoralkylvinylether, einem Copolymer von Hexafluorpropylen und Tetrafluorethylen, Poly(ethylen-co-chlortrifluorethylen), Poly(chlortrifluorethylen), Poly(ethylenco-tetrafluorethylen) und Poly(vinylidenfluorid) ausgewählt wird.

**13.** Material nach irgendeinem der Ansprüche 1 bis 12, **dadurch gekennzeichnet, dass** das Verbundmaterial eine ebene Form hat und eine X-Y-Ebene einschließt, und

wobei der Wärmeausdehnungskoeffizient (WAK) der X-Y-Ebene innerhalb des Bereichs von über ca. 11 ppm/°C und unter ca. 20 ppm/°C liegt.

**14.** Material nach irgendeinem der Ansprüche 1 bis 13, **dadurch gekennzeichnet, dass** das Verbundmaterial eine ebene Form hat und eine X-Y-Ebene einschließt, und

wobei das Füllermaterial in einem prozentualen Volumenanteil vorhanden ist, der innerhalb der 3% der Volumen-% liegt, die für das Erreichen einer Dimensionsänderung von Null in der X-Y-Ebene erforderlich sind.

**15.** Material nach irgendeinem der Ansprüche 1 bis 14, dadurch gekennzeichet, dass das Verbundmaterial eine K im Bereich von 3,0 bis 20,0 aufweist.

**16.** Material nach irgendeinem der Ansprüche 1 bis 15, **dadurch gekennzeichnet, dass** der aus Partikeln bestehende keramische Füller in einer Menge von 60 Volumen-% vorhanden ist, und
wobei der erste keramische Füller Titandioxid und der zweite keramische Füller Siliciumdioxid umfasst.

**17.** Material nach Anspruch 16, **dadurch gekennzeichnet, dass** das Volumenverhältnis zwischen Titandioxid und Siliciumdioxid ca. 50:10 beträgt.

**18.** Material nach Anspruch 16, **dadurch gekennzeichnet, dass** das Volumenverhältnis zwischen Titandioxid und Siliciumdioxid ca. 34:26 beträgt.

**19.** Material nach irgendeinem der Ansprüche 1 bis 18, **gekennzeichnet durch** mindestens ein zweites Keramikmaterial mit einer K' < 30.

**20.** Material nach irgendeinem der Ansprüche 1 bis 18, **gekennzeichnet durch** mindestens ein zweites Keramikmaterial mit einer K' < 30,
wobei die Mischung der keramischen Füller in einem prozentualen Volumenanteil vorhanden ist, der innerhalb der 3% der Volumen-% liegt, die für das Erreichen einer Dimensionsänderung von Null erforderlich sind.

**Revendications**

**1.** Matériau composite constituant un substrat électrique, lequel comprend

(1) une matrice fluoro-polymérique ;
(2) un matériau de remplissage céramique particulaire, ledit matériau de remplissage étant **caractérisé par** un mélange de

(a) au moins un premier matériau céramique présentant une K' > 30 ; et
(b) au moins un second matériau céramique présentant une composition chimique autre que ledit premier matériau céramique, ledit mélange de matériaux de remplissage céramiques étant proportionné dans un rapport efficace permettant de produire le matériau composite avec une stabilité dimensionnelle dont la grandeur absolue varie de moins de 0,1%.

**2.** Matériau selon la revendication 1, **caractérisé en ce que** ledit premier matériau céramique est choisi parmi le groupe constitué de dioxyde de titane, $SrTiO_3$, $CaTiO_3$, et $BaTiO_4$.

**3.** Matériau selon la revendication 1 ou 2, **caractérisé en ce que** ledit second matériau céramique est choisi parmi le groupe constitué de silice amorphe fondue, de silice microcristalline, de billes de verre, $Al_2O_3$, $MgO$ et $Ba_2Ti_9O_{20}$.

**4.** Matériau selon l'une quelconque des revendications 1 à 3, **caractérisé en ce que** ledit matériau de remplissage particulaire présente un facteur diélectrique de perte < 0,005 à des fréquences supérieures à 500 Mhz.

**5.** Matériau selon l'une quelconque des revendications 1 à 4, **caractérisé en ce que** ladite matrice fluoro-polymérique est présente en une quantité comprise entre environ 30 et 50 pour cent du volume total du matériau constituant le substrat.

**6.** Matériau selon l'une quelconque des revendications 1 à 5, **caractérisé en ce que** ledit matériau de remplissage est présent en une quantité comprise entre environ 50 et 70 pour cent du volume total du matériau constituant le substrat.

**7.** Matériau selon l'une quelconque des revendications 1 à 6, comprenant un revêtement hydrophobe sur lesdits matériaux céramiques.

**8.** Matériau selon la revendication 7, **caractérisé en ce que** ledit revêtement sur lesdits matériaux céramiques est choisi parmi le groupe constitué de silanes, de titanates et de zirconates.

**9.** Matériau selon l'une quelconque des revendications 1 à 8 comprenant au moins une couche de métal sur au moins une portion de la surface du matériau composite.

**10.** Matériau selon la revendication 9, **caractérisé en ce que** la couche de métal comprend du cuivre.

**11.** Matériau selon l'une quelconque des revendications 1 à 10, **caractérisé en ce que** ledit matériau composite présente une forme plane et comprend un plan X-Y, et dans lequel le coefficient d'expansion thermique (CTE) du matériau composite est fondamentalement égal au coefficient d'expansion thermique (CTE) du cuivre.

**12.** Matériau selon l'une quelconque des revendications 1 à 11, **caractérisé en ce que** ladite matrice fluoro-polymérique est choisie parmi le groupe constitué de polytrétafluoroéthylène, d'un copolymère de trétafluoroéthylène et de perfluoroalkylvinyléther, d'un copolymère d'hexafluoropropylène et de tétrafluoroéthylène, le poly(éthylène-co-chlorotrifluoroéthylène), le poly(chlorotrifluoroéthylène), le poly(éthylène-co-tétrafluoroéthylène) et le poly(fluorure de vinylidène).

**13.** Matériau selon l'une quelconque des revendications 1 à 12, **caractérisé en ce que** ledit matériau composite présente une forme plane et comprend un plan X-Y, et dans lequel le coefficient d'expansion thermique (CTE) dudit plan X-Y se situe dans une gamme de valeurs supérieures à environ 11 ppm/°C et inférieures à environ 20 ppm/°C.

**14.** Matériau selon l'une quelconque des revendications 1 à 13, **caractérisé en ce que** ledit matériau composite présente une forme plane et comprend un plan X-Y, et dans lequel ledit matériau de remplissage est présent dans un % en volume qui se situe dans les 3% du % en volume nécessaire pour parvenir à une variation dimensionnelle égale à zéro dans ledit plan X-Y.

**15.** Matériau selon l'une quelconque des revendications 1 à 14, **caractérisé en ce que** ledit matériau composite présente une K située dans une gamme de valeurs comprises entre 3,0 et 20,0.

**16.** Matériau selon l'une quelconque des revendications 1 à 15, **caractérisé en ce que** ledit matériau de remplissage céramique particulaire est présent en une quantité valant 60% en volume, et dans lequel ledit premier matériau de remplissage céramique comprend du dioxyde de titane ; et ledit second matériau de remplissage céramique comprend de la silice.

**17.** Matériau selon la revendication 16, **caractérisé en ce que** le rapport volumétrique de dioxyde de titane à la silice est d'environ 50 :10.

**18.** Matériau selon la revendication 16, **caractérisé en ce que** le rapport volumétrique de dioxyde de titane à la silice est d'environ 34 : 26.

**19.** Matériau selon l'une quelconque des revendications 1 à 18, **caractérisé par** au moins un second matériau céramique présentant une valeur K' < 30.

**20.** Matériau selon l'une quelconque des revendications 1 à 18, **caractérisé par** au moins un second matériau céramique présentant une valeur K' < 30, ledit mélange de matériaux de remplissage céramiques étant présent dans un % de volume qui se situe dans les 3% du % en volume nécessaire pour parvenir à une variation dimensionnelle égale à zéro.

*FIG. 1*

DIMSTAB (% CHANGE ON TCH AND BAKE VS. XY CTE (ppm/C)

FIG. 2

% CHANGE IN DIMENSION VS. FILLER CONTENT

FIG. 3

■ COARSE PSD
● FINE PSD

EP 0 695 116 B1

K' VS. TITANIA LEVEL

FIG. 4

EP 0 695 116 B1

PERCENT DIMENSIONAL CHANGE VS. VOL % ASH

FIG. 5

EP 0 695 116 B1